# EUROPEAN PATENT APPLICATION

(11) **EP 4 231 299 A1**
(43) Date of publication of application: **23.08.2023**
(21) Application number: 20961995.6
(22) Date of filing: 20.11.2020
(51) Int. Cl.: G11C 13/00

(54) **MEMORY DATA READING CIRCUIT AND MEMORY**

(71) Applicant: Huawei Technologies Co., Ltd., Shenzhen, Guangdong 518129 (CN)
(72) Inventor: CAI, Jiangzheng, Shenzhen, Guangdong 518129 (CN); BU, Mingen, Shenzhen, Guangdong 518129 (CN); OUYANG, Sheng, Shenzhen, Guangdong 518129 (CN)
(74) Representative: Maiwald GmbH
(86) International application number: PCT/CN2020/130442
(87) International publication number: WO 2022/104704

(57) **Abstract**

A stored data reading circuit and a memory are provided, which relate to the field of integrated circuit technologies, to resolve a problem that data read by the stored data reading circuit is inaccurate. The stored data reading circuit (01) includes a first current mirror (301), a first resistor (303), and a voltage amplifier (40). An input end (a) of the first current mirror (301) is connected to a first data reading end (p) of a memory cell, and an output end (b) of the first current mirror (301) is connected to a ground terminal via the first resistor (303). The first current mirror (301) is configured to: amplify a current output at the first data reading end (p) of the memory cell to a first mirror current (IRO) through mirroring, and output the first mirror current (IRO) to the output end (b) of the first current mirror (301). A first input end (c) of the voltage amplifier (40) is connected to the output end (b) of the first current mirror (301), a second input end (d) of the voltage amplifier (40) is configured to receive a reference voltage (Iref), and an output end (e) of the voltage amplifier (40) is connected to an output end of the stored data reading circuit (01).

## Description

### TECHNICAL FIELD

This application relates to the field of integrated circuit technologies, and in particular, to a stored data reading circuit and a memory.

### BACKGROUND

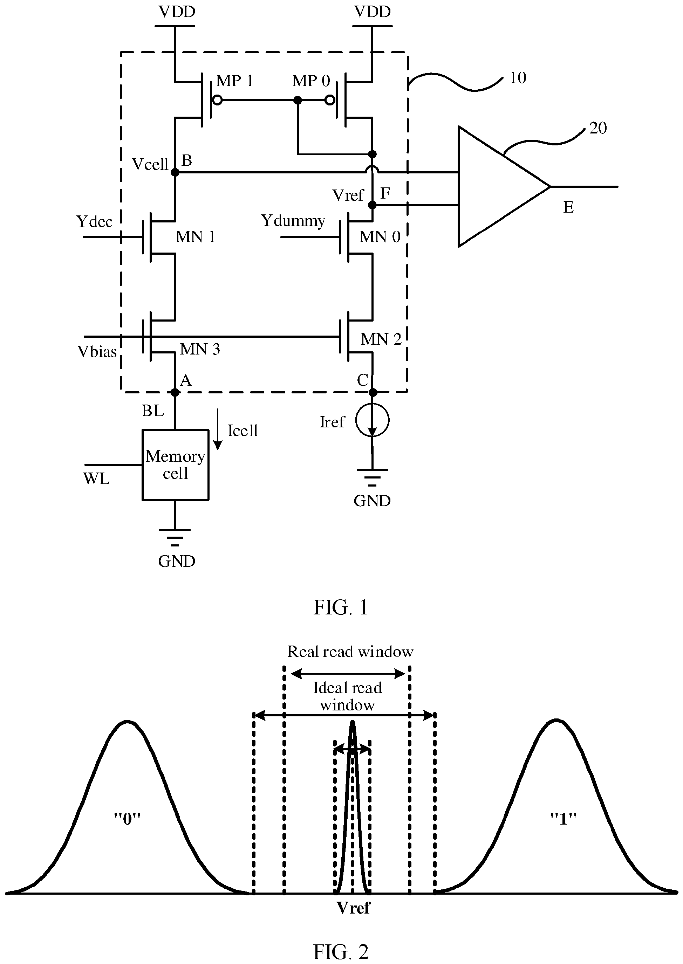

Currently, FIG. 1 shows a structure of a stored data reading circuit (generally a sense amplifier (sense amplifier, SA)) in a non-volatile memory (non-volatile memory, NVM). The stored data reading circuit includes a first-stage amplifier 10 and a second-stage amplifier 20. The first-stage amplifier 10 includes transistors MP 0, MP 1, MN 0, MN 1, MN 2, and MN 3. The MP 1, the MN 1, and the MN 3 are sequentially connected in series between a power supply VDD and a ground GND, and the MP 0, the MN 0, and the MN 2 are sequentially connected in series between a power supply VDD and a ground GND. A control end of the MP 1 is connected to a control end of the MP 0, the MN 0 and the MP 0 are connected at a node F, and the control end of the MP 0 is connected to the node F. Both the MN 0 and the MN 1 are switch transistors, a control end of the MN 1 is connected to a control line Ydec, a voltage provided by the control line Ydec is used to control conduction and disconnection of the MN 1, and the MN 1 is configured to control conduction and disconnection between a first input end A and a first output end B of the first-stage amplifier 10. A control end of the MN 0 is connected to a control line Ydummy, a voltage provided by the control line Ydummy is used to control conduction and disconnection of the MN 0, and the MN 0 is configured to control conduction and disconnection between a second input end C and a second output end F of the first-stage amplifier 10. Control ends of the MN 2 and the MN 3 are both connected to a bias voltage end, and the bias voltage end provides a bias voltage Vbias for the control ends of the MN 2 and the MN 3. The MN 2 is configured to adjust a magnitude of a reference current Iref, and the MN 3 is configured to adjust a magnitude of a current Icell flowing from the first input end A to the first output end B. The first input end A of the first-stage amplifier 10 is connected to a data reading end of a memory cell (memory cell) through a bit line BL, and the memory cell is further connected to a word line WL. After the memory cell is enabled by the word line WL, the current Icell that flows through the memory cell and that is provided by the data reading end of the memory cell is input to the first input end A of the first-stage amplifier 10. The first-stage amplifier 10 converts the current Icell input from the first input end A into a voltage signal Vcell, and outputs the voltage signal Vcell from the first output end B of the first-stage amplifier 10. The first-stage amplifier 10 further converts a reference current Iref input from the second input end C into a voltage signal Vref, and outputs the voltage signal Vref from the second output end F of the first-stage amplifier 10.

The first output end B and the second output end F of the first-stage amplifier 10 are respectively connected to two input ends of the second-stage amplifier 20. When a voltage Vcell₁ at the first output end B of the first-stage amplifier 10 is less than the reference voltage Vref at the second output end F, a low-level voltage (for example, 0) is output at an output end E of the second-stage amplifier 20; in this case, it may be determined that data stored in the memory cell is "1"; or when a voltage Vcell0 at the first output end B of the first-stage amplifier 10 is greater than the reference voltage Vref at the second output end F, a high-level voltage (for example, a voltage of the power supply VDD) is output at an output end E of the second-stage amplifier 20; in this case, it can be determined that data stored in the memory cell is "0".

As shown in FIG. 2, an intermediate reference voltage Vref can be found only if there is a large window when the memory cell stores "1" and "0" (that is, there is large a difference between the voltage Vcell₁ that is at the first output end B of the first-stage amplifier 10 and that corresponds to a case in which the memory cell stores "1" and the voltage Vcell₀ that is at the first output end B of the first-stage amplifier 10 and that corresponds to a case in which the memory cell stores "0"), . The voltage Vcell at the first output end B is compared with the reference voltage Vref at the second output end F to distinguish between "0" and " 1". However, due to a process deviation, on one hand, a real read window may be less than an ideal read window. If a difference between the voltage Vcell at the first output end B and the reference voltage Vref is less than sensitivity of the second-stage amplifier 20, or the voltage Vcell at the first output end B is less than the reference voltage Vref when the memory cell stores "0", a value output at the output end E of the second-stage amplifier 20 may be incorrect. On the other hand, a fluctuation of the reference voltage Vref may be caused due to the process deviation. In this case, when the voltage Vcell at the first output end B is compared with the reference voltage Vref, the value output at the output end E of the second-stage amplifier 20 may also be incorrect. Consequently, it is difficult to distinguish between "0" and "1", and it is difficult for a memory to read correct data.

### SUMMARY

Embodiments of this application provide a stored data reading circuit and a memory, to resolve a problem that data read by the stored data reading circuit is inaccurate.

To achieve the foregoing objectives, the following technical solutions are used in this application.

According to a first aspect, a stored data reading circuit is provided. The stored data reading circuit includes a first current mirror, a first resistor, and a voltage amplifier. An input end of the first current mirror is connected to a first data reading end of a memory cell, and an output end of the first current mirror is connected to a ground terminal via the first resistor. The first current mirror is configured to: amplify a current output at the first data reading end of the memory cell to a first mirror current through mirroring, and output the first mirror current to the output end of the first current mirror. A first input end of the voltage amplifier is connected to the output end of the first current mirror, a second input end of the voltage amplifier is configured to receive a reference voltage, and an output end of the voltage amplifier is connected to an output end of the stored data reading circuit. Because the first current mirror amplifies the current Icell output at the first data reading end of the memory cell into the first mirror current IR 0, and outputs the first mirror current IR 0 to the output end b of the first current mirror, and a voltage Vdata at the output end b (that is, at a node D) of the first current mirror is equal to a product of the first mirror current IR 0 and the first resistor, when the memory cell stores "1" or "0", a magnitude of the first mirror current IR 0 (where the magnitude of the first mirror current IR 0 may be adjusted by adjusting a length-width ratio of a transistor in a first current mirror 301) and a magnitude of the first resistor may be adjusted to increase the voltage Vdata at the node D, thereby increasing a window when the memory cell stores "1" and "0", that is, increasing a difference between a voltage Vdata1 at the node D when the memory cell stores "1" and a voltage VdataO at the node D when the memory cell stores "0". In this way, even if the window when the memory cell stores "1" and "0" is decreased due to a process deviation, or even if the reference voltage Vref fluctuates, the window when the memory cell stores "1" and "0" has been amplified after a first amplifier is used and can be amplified up to a rail-to-rail level, that is, the voltage Vdata at the node D can reach a maximum power voltage. Therefore, the voltage amplifier can accurately determine the Vdata and reference voltage Vref. In this way, data stored in the memory cell can be distinguished from "0" to "1", ensuring that a memory can correctly read the data.

In a possible implementation, the stored data reading circuit further includes a first inverter and a first multiplexer, where an input end of the first inverter is connected to the output end of the first current mirror, an output end of the first inverter is connected to a first input end of the first multiplexer, the output end of the voltage amplifier is connected to a second input end of the first multiplexer, and an output end of the first multiplexer is connected to the output end of the stored data reading circuit. The voltage amplifier is configured to perform inverting output on a difference between a voltage input at the first input end of the voltage amplifier and a voltage input at the second input end of the voltage amplifier. Because the stored data reading circuit includes the voltage amplifier, the first inverter, and the first multiplexer, the first multiplexer may choose to output a signal output at the output end of the first inverter or a signal output at the output end of the voltage amplifier. Specifically, in a first phase, the output end of the first multiplexer may choose to quickly output the signal output at the output end of the voltage amplifier. Because the difference between the voltage input at the first input end of the voltage amplifier and the reference voltage received at the second input end of the voltage amplifier in the first phase may not reach a particularly ideal range, there is a probability of misreading. However, a threshold voltage of the first inverter is generally large. Therefore, in a second phase, the output end of the first multiplexer may choose to output the signal output at the output end of the first inverter. In a relatively poor process deviation or in an extreme case, there may also be an error in the signal output at the output end of the first multiplexer in the second phase. Because the window has been completely amplified in a third phase, the output end of the first multiplexer may choose to output the signal output at the output end of the voltage amplifier in the third phase. In a possible implementation, the stored data reading circuit further includes a reference current source, the second input end of the voltage amplifier is connected to the reference current source, and the reference voltage is provided for the second input end of the voltage amplifier by using the reference current source. A magnitude of the reference voltage may be adjusted by adjusting a magnitude of the reference current source. In addition, the reference current source is used to provide the reference voltage for the second input end of the voltage amplifier, which can simplify a structure of the stored data reading circuit.

In a possible implementation, the stored data reading circuit further includes a reference current generation circuit, and the second input end of the voltage amplifier is connected to an output end of the reference current generation circuit. The reference current generation circuit includes a second current mirror and a second resistor. An input end of the second current mirror is connected to a second data reading end of a first reference memory cell and a second reference memory cell that are connected in parallel, an output end of the second current mirror is connected to a ground terminal via the second resistor, and the output end of the second current mirror is further connected to the second input end of the voltage amplifier. The second current mirror is configured to: amplify a total current output at the second data reading end to a second mirror current through mirroring, and output the second mirror current to the output end of the second current mirror. The first reference memory cell and the second reference memory cell are in different storage states. The second input end of the voltage amplifier is connected to the output end of the reference current generation circuit. In this way, the reference voltage may be provided for the second input end of the voltage amplifier via the reference current generation circuit. In addition, because the reference current generation circuit is connected to the second data reading end of the first reference memory cell and the second reference memory cell that are connected in parallel, the total current output at the second data reading end of the first reference memory cell and the second reference memory cell is a sum of a current output by the first reference memory cell and a current output by the second reference memory cell. Therefore, the storage states of the first reference memory cell and the second reference memory cell are opposite, to ensure that the reference voltage provided at the output end of the reference current generation circuit is an intermediate value of a voltage when the memory cell stores "1" and a voltage when the memory cell stores "0", which improves the accuracy of the reference voltage and further ensures that the stored data reading circuit can correctly read the data.

In a possible implementation, an enable signal end of the voltage amplifier is connected to an enable signal control circuit. The enable signal control circuit provides an enable signal for the enable signal end.

In a possible implementation, the stored data reading circuit further includes a second multiplexer, an enable signal end of the voltage amplifier is connected to an output end of the second multiplexer, an enable signal control circuit is connected to a first input end of the second multiplexer, and the output end of the reference current generation circuit is connected to a second input end of the second multiplexer. The enabling signal end of the voltage amplifier is connected to the output end of the second multiplexer, and the second input end of the second multiplexer is connected to the output end of the reference current generation circuit. Because the input end of the second current mirror in the reference current generation circuit is connected to the second data reading end of the first reference memory cell and the second reference memory cell that are connected in parallel, and the first reference memory cell and the second reference memory cell are known reference units, it may be determined whether the second input end of the voltage amplifier receives the correct reference voltage within a predetermined time period. In this way, when the reference current generation circuit provides the correct reference voltage, a signal may also be provided for the second input end of the second multiplexer, and the signal is provided for the enable signal end of the voltage amplifier. In this case, the enable signal end of the voltage amplifier provides the enable signal for the voltage amplifier to enable the voltage amplifier, and the voltage amplifier outputs the signal from the output end of the voltage amplifier based on the difference between the reference voltage input at the first input end and the voltage input at the second input end. In this case, the voltage received at the first input end of the voltage amplifier is stable, which improves the stability of the signal output at the output end of the voltage amplifier.

In a possible implementation, the stored data reading circuit further includes an error detection circuit, and a control end of the first multiplexer is electrically connected to the error detection circuit. The error detection circuit is connected to the output end of the first inverter and the output end of the voltage amplifier. The error detection circuit is configured to output an error detection signal based on a signal output at the output end of the first inverter and a signal output at the output end of the voltage amplifier. The first multiplexer determines, based on the error detection signal, that the output end of the first multiplexer outputs the signal output at the output end of the first inverter or the signal output at the output end of the voltage amplifier. In this way, the output end of the first multiplexer can accurately output the signal.

In a possible implementation, the stored data reading circuit further includes a first switch unit, and the input end of the first current mirror is connected to the data reading end of the memory cell via the first switch unit. The first switch unit may control the input end of the first current mirror to be conducted or disconnected from the data reading end of the memory cell.

In a possible implementation, the reference current generation circuit further includes a second switch unit, and the input end of the second current mirror is connected to the second data reading end via the second switch unit. The second switch unit may control the input end of the second current mirror to be connected to or disconnected from the second data reading end.

In a possible implementation, the first current mirror includes a first transistor and a second transistor, where a first end of the first transistor and a first end of the second transistor are both connected to a first voltage end, a second end of the first transistor is connected to the first data reading end, a second end of the second transistor is connected to the first resistor, a control end of the first transistor is connected to a control end of the second transistor, and the control end of the first transistor is connected to the second end of the first transistor.

In a possible implementation, the first switch unit includes a third transistor; a control end of the third transistor is connected to a first control line, a first end is connected to the input end of the first current mirror, and a second end is connected to the first data reading end.

In a possible implementation, the first resistor includes a fourth transistor, a control end of the fourth transistor is connected to a first end, a second end of the fourth transistor is grounded, and the first end of the fourth transistor is connected to the output end of the first current mirror.

In a possible implementation, the second current mirror includes a fifth transistor and a sixth transistor, where a first end of the fifth transistor and a first end of the sixth transistor are both connected to a second voltage end, a second end of the fifth transistor is connected to the second data reading end, a second end of the sixth transistor is connected to the second input end of the voltage amplifier, a control end of the fifth transistor is connected to a control end of the sixth transistor, and the control end of the fifth transistor is connected to the second end of the fifth transistor.

In a possible implementation, the second switch unit includes a seventh transistor; a control end of the seventh transistor is connected to a second control line, a first end is connected to the input end of the second current mirror, and a second end is connected to the second data reading end.

In a possible implementation, the second resistor includes an eighth transistor, a control end of the eighth transistor is connected to a first end, a second end of the eighth transistor is grounded, and the first end of the eighth transistor is connected to the second input end of the voltage amplifier.

According to a second aspect, a stored data reading circuit is provided. The stored data reading circuit includes a first current mirror, a first resistor, and a first inverter. An input end of the first current mirror is connected to a first data reading end of a memory cell, and an output end of the first current mirror is connected to a ground terminal via the first resistor. The first current mirror is configured to: amplify a current output at the first data reading end of the memory cell to a first mirror current through mirroring, and output the first mirror current to the output end of the first current mirror. An input end of the first inverter is connected to the output end of the first current mirror, and an output end of the first inverter is connected to an output end of the stored data reading circuit. Because the first current mirror amplifies the current Icell output by the memory cell into the first mirror current IR 0, and outputs the first mirror current IR 0 to the output end b of the first current mirror, and a voltage Vdata at the output end b (that is, at a node D) of the first current mirror is equal to a product of the first mirror current IR 0 and the first resistor, when the memory cell stores "1" or "0", the first mirror current IR 0 and the first resistor may be adjusted to increase the voltage Vdata at the node D, thereby increasing a window when the memory cell stores "1" and "0", that is, increasing a difference between a voltage Vdata1 at the node D when the memory cell stores "1" and a voltage VdataO at the node D when the memory cell stores "0". In this way, even if the window when the memory cell stores "1" and "0" is decreased due to a process deviation, or even if the reference voltage Vref fluctuates, the window when the memory cell stores "1" or "0" has been amplified. For the first inverter, when the voltage Vdata at the output end of the first current mirror is greater than a threshold voltage of the first inverter, a low-level voltage is output at the output end of the first inverter; or when the voltage Vdata at the output end of the first current mirror is less than a threshold voltage of the first inverter, a high-level voltage is output at the output end of the first inverter. Therefore, the first inverter can accurately determine the Vdata. In this way, data stored in the memory cell can be distinguished from "0" to "1", ensuring that a memory can correctly read the data.

In a possible implementation, the stored data reading circuit further includes a first switch unit, and the input end of the first current mirror is connected to the data reading end of the memory cell via the first switch unit. The first switch unit may control the input end of the first current mirror to be conducted or disconnected from the data reading end of the memory cell.

In a possible implementation, the first current mirror includes a first transistor and a second transistor. A first end of the first transistor and a first end of the second transistor are both connected to a first voltage end, a second end of the first transistor is connected to the first data reading end, a second end of the second transistor is connected to the first resistor, a control end of the first transistor is connected to a control end of the second transistor, and the control end of the first transistor is connected to the second end of the first transistor.

In a possible implementation, the first switch unit includes a third transistor; a control end of the third transistor is connected to a first control line, a first end is connected to the input end of the first current mirror, and a second end is connected to the first data reading end.

In a possible implementation, the first resistor includes a fourth transistor, a control end of the fourth transistor is connected to a first end, a second end of the fourth transistor is grounded, and the first end of the fourth transistor is connected to the output end of the first current mirror. According to a third aspect, a memory is provided. The memory includes a plurality of memory cells distributed in an array and at least one of the foregoing stored data reading circuits. The memory has a technical effect the same as that in the foregoing embodiment. Details are not described herein again.

According to a fourth aspect, a control method of a stored data reading circuit is provided. The control method includes: In a first phase, a first switch unit is in a conduction state, and after a memory cell is enabled by a word line, a first data reading end of the memory cell outputs a current to an input end of a first current mirror, and the first current mirror amplifies the current output at the first data reading end of the memory cell into a first mirror current through mirroring, and outputs the first mirror current to an output end of the first current mirror. A voltage amplifier outputs a signal to an output end of the voltage amplifier according to a voltage input at a first input end of the voltage amplifier and a reference voltage received at a second input end. The control method of the stored data reading circuit has a same technical effect as that in the foregoing embodiment. Details are not described herein again.

In a possible implementation, the stored data reading circuit further includes a first inverter and a first multiplexer. In the first phase, the first multiplexer outputs the signal output by the voltage amplifier. After the first phase, the foregoing control method further includes: In a second phase, the voltage amplifier is not enabled. If a signal output by the first inverter is the same as the signal output by the first multiplexer in the first phase, the first multiplexer keeps outputting the signal output by the voltage amplifier in the first phase; or if a signal output by the first inverter is different from the signal output by the first multiplexer in the first phase, the first multiplexer is controlled to output the signal output by the first inverter. In the first phase, an output end of the first multiplexer quickly outputs the signal in a short time. In this case, a difference between the voltage input at the first input end of the voltage amplifier and the reference voltage input at the second input end may not reach a particularly ideal range, and there is a probability of misreading. On one hand, a threshold voltage of the first inverter is generally large; and on the other hand, a reading time in the second phase is later than a reading time in the first phase. Therefore, there is a high probability that the signal output by the first inverter is accurate. In this way, in the second phase, when the signal output by the first inverter is different from the signal output by the voltage amplifier in the first phase, the signal output at the output end of the first multiplexer is the signal output by the first inverter.

In a possible implementation, after the second phase, the control method further includes: In a third phase, an enabling signal end of the voltage amplifier provides an enabling signal for the voltage amplifier to enable the voltage amplifier. If the signal output by the voltage amplifier is the same as the signal output by the first multiplexer in the second phase, the first multiplexer keeps outputting the signal output by the first multiplexer in the second phase; or if the signal output by the voltage amplifier is different from the signal output by the first multiplexer in the second phase, the first multiplexer is controlled to output the signal output by the voltage amplifier. In a relatively poor process deviation or in an extreme case, there may also be an error in the signal output at the output end of the first multiplexer in the second phase. Because the window has been completely amplified in the third phase, the voltage amplifier can perform correct amplification even in the relatively poor process deviation or in the extreme case, thereby ensuring correctness of the signal output at the output end of the voltage amplifier.

### BRIEF DESCRIPTION OF DRAWINGS

FIG. 1 is a schematic structural diagram of a stored data reading circuit according to the conventional technology;
FIG. 2 is a schematic diagram of a comparison between a real read window and an ideal read window according to the conventional technology;
FIG. 3 is a schematic structural diagram of a memory according to an embodiment of this application;
FIG. 4 is a schematic structural diagram of a stored data reading circuit according to an embodiment of this application;
FIG. 5 is a schematic structural diagram of a stored data reading circuit according to another embodiment of this application;
FIG. 6 is a schematic structural diagram of a stored data reading circuit according to still another embodiment of this application;
FIG. 7 is a schematic structural diagram of a stored data reading circuit according to yet another embodiment of this application;
FIG. 8 is a schematic structural diagram of a stored data reading circuit according to still yet another embodiment of this application;
FIG. 9 is a schematic structural diagram of a stored data reading circuit according to a further embodiment of this application;
FIG. 10 is a sequence diagram of control signals used to drive the stored data reading circuit shown in FIG. 9;
FIG. 11 is a waveform diagram of several control signals in a stored data reading circuit according to an embodiment of this application;
FIG. 12 is a waveform diagram of several control signals in a stored data reading circuit according to another embodiment of this application;
FIG. 13 is a waveform diagram of several control signals in a stored data reading circuit according to still another embodiment of this application; and
FIG. 14 is a waveform diagram of several control signals in a stored data reading circuit according to yet another embodiment of this application.

### Reference numerals:

01-Stored data reading circuit; 10-First-stage amplifier; 20-Second-stage amplifier; 30-First amplifier; 40-Voltage amplifier; 50-Reference current generation circuit; 60-First multiplexer; 70-Enable signal control circuit; 80-Second multiplexer; 90-Error detection circuit; 301-First current mirror; 302-First switch unit; 303-First resistor; 501-Second current mirror; 502-Second switch unit; 503-Second resistor.

### DESCRIPTION OF EMBODIMENTS

The following describes the technical solutions in embodiments of this application with reference to the accompanying drawings in the embodiments of this application. It is clearly that the described embodiments are merely some rather than all of embodiments of this application.

Unless defined otherwise, all technical and scientific terms used herein have the same meaning as commonly understood by a person of ordinary skill in the art to which this disclosure belongs.

The following terms "first", "second" and the like are merely intended for ease of description, and shall not be understood as an indication or implication of relative importance or implicit indication of a quantity of indicated technical features. Therefore, a feature limited by "first ", "second" and the like may explicitly indicate or implicitly include one or more such features. In addition, the term "electrical connection" may be a direct electrical connection, or may be an indirect electrical connection through an intermediate medium.

It should be noted that in this application, the term such as "example" or "for example" is used to represent giving an example, an illustration, or a description. Any embodiment or design scheme described as an "example" or "for example" in this application should not be explained as being more preferred or having more advantages than another embodiment or design scheme. Exactly, use of the word such as "example" or "for example" is intended to present a relative concept in a specific manner.

A memory is an important part of the integrated circuit industry, and is widely used in key fields such as computing, communication, and national defense. A design of a memory with high reliability, high performance, large capacity and low costs has become a goal of the integrated circuit industry. High reliability of the memory is one of the most basic and key indicators. Only when data is correctly stored and read can ensure normal operation of an entire system.

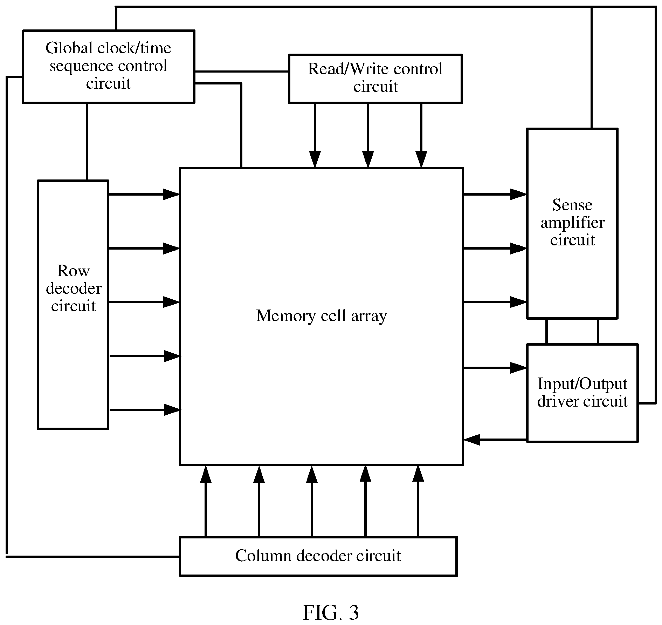

An embodiment of this application provides a memory. FIG. 3 shows a structure of the memory. The memory includes a memory cell array, a row decoder circuit, a column decoder circuit, a global clock/time sequence control circuit, a read/write control circuit, an input/output driver circuit, and at least one stored data reading circuit. The memory cell array includes a plurality of memory cells distributed in an array. The global clock/time sequence control circuit is separately connected to the row decoder circuit, the column decoder circuit, the memory cell array, the read/write control circuit, and the input/output driver circuit, and is configured to perform time sequence control. The row decoder circuit is connected to the memory cell array, and enables a memory cell in a corresponding row according to a row address, to perform site selection on the memory cell on the corresponding row. The column decoder circuit is connected to the memory cell array, and after a memory cell on the corresponding row is enabled, the column decoder circuit performs site selection on a memory cell in a corresponding column according to a column address, to select the memory cell for performing a read operation or a write operation. The read/write control circuit is connected to the memory cell array, and is configured to be controlled to perform a read operation or a write operation on the memory cell array. A sensitive stored data reading circuit is a data reading module, configured to read data. The input/output driver circuit is separately connected to the sensitive stored data reading circuit and the memory cell array, and is configured to perform corresponding input or output processing.

In some embodiments, the memory includes m stored data reading circuits, and one stored data reading circuit is connected to n memory cells, where m and n are both positive integers, m≥2, and n≥2.

With a decrease in a process size and the emergence of various novel memory cells, process deviations and new features of the memory cells have increasingly affected the reliability of the memory. The stored data reading circuit is most sensitive to the new features and the process deviations of the memory cells. Therefore, in an increasingly severe process deviation and with a new process, it is essential to ensure that the sensitive stored data reading circuit in the memory works correctly. In view of this, an embodiment of this application further provides a stored data reading circuit, and the stored data reading circuit may be applied to the foregoing memory.

The following provides three specific embodiments to describe a structure of a stored data reading circuit by using examples.

### Embodiment 1

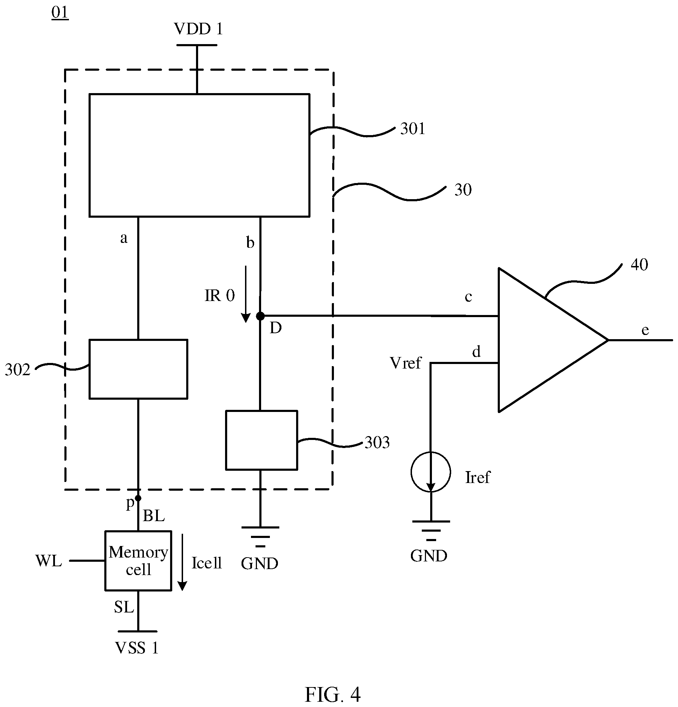

As shown in FIG. 4, the stored data reading circuit 01 includes a first current mirror 301, a first resistor 303, and a voltage amplifier 40. The first current mirror 301, the first resistor 303, and the like jointly constitute a first amplifier 30.

An input end a of the first current mirror 301 is connected to a first data reading end p of a memory cell, an output end b of the first current mirror 301 is connected to a ground GND terminal via the first resistor 303, and the first current mirror 301 is further connected to a power voltage (for example, a voltage at a first voltage end VDD 1). The memory cell is connected to a word line WL, a bit line BL, and a source line SL. The source line SL may be connected to a third voltage end VSS 1, or may be connected to the ground terminal. After the memory cell is enabled by the word line WL, the first data reading end p of the memory cell outputs a current Icell to the input end a of the first current mirror 301. The first current mirror 301 is configured to: amplify the current Icell output at the first data reading end p of the memory cell to a first mirror current IR 0 through mirroring, and output the first mirror current IR 0 to the output end b of the first current mirror 301.

It should be noted that, in some embodiments of this application, the voltage amplifier 40 may be a sense amplifier.

The first current mirror 301 amplifies the current Icell output at the first data reading end p of the memory cell to the first mirror current IR 0 through mirroring. A mirroring amplification multiple is related to a structure of the first current mirror 301, and the mirroring amplification multiple of the first current mirror 301, that is, a magnitude of the first mirror current IR 0, may be adjusted by adjusting the structure of the first current mirror 301. Specifically, when the first current mirror 301 includes a transistor, the mirroring amplification multiple of the first current mirror 301, that is, the magnitude of the first mirror current IR 0, may be adjusted by adjusting a width-to-length ratio of the transistor. A first input end c of the voltage amplifier 40 is connected to the output end b of the first current mirror 301, a second input end d of the voltage amplifier 40 is configured to receive a reference voltage Vref, and an output end e of the voltage amplifier 40 is connected to an output end of the stored data reading circuit 01.

It should be noted that the first input end c of the voltage amplifier 40 is connected to the output end b of the first current mirror 301, the first input end c of the voltage amplifier 40 receives a voltage Vdata at a node data (D), and the second input end d of the voltage amplifier 40 receives the reference voltage Vref. In view of this, in some embodiments, when the Vdata is greater than the Vref, a high-level voltage is output at the output end e of the voltage amplifier 40, for example, the voltage at the first voltage end VDD 1; or when the Vdata is less than the Vref, a low-level voltage is output at the output end e of the voltage amplifier 40, for example, 0. In a case in which the voltage amplifier 40 includes an inverter, or the voltage amplifier 40 is an amplifier of a special structure (for example, the voltage amplifier 40 is a differential amplifier), in some other embodiments, when the Vdata is greater than the Vref, a low-level voltage is output at the output end e of the voltage amplifier 40, for example, 0; or when the Vdata is less than the Vref, a high-level voltage is output at the output end e of the voltage amplifier 40, for example, the voltage at the first voltage end VDD 1.

In addition, the voltage Vdata at the node D is equal to a product of the first mirror current IR 0 and the first resistor 303. In view of this, the Vdata may be adjusted by adjusting a magnitude of the first mirror current IR 0 and a magnitude of the first resistor 303. In other words, the first mirror current IR 0 output by the first current mirror 301 may be increased, and the first resistor 303 may be increased, so that the voltage Vdata received at the first input end c of the voltage amplifier 40 is significantly increased.

In this embodiment of this application, the stored data reading circuit 01 includes the first current mirror 301, the first resistor 303, and the voltage amplifier 40. The input end a of the first current mirror 301 is connected to the first data reading end p of the memory cell, the output end b of the first current mirror 301 is connected to the ground terminal via the first resistor 303, the first input end c of the voltage amplifier 40 is connected to the output end b of the first current mirror 301, the second input end d of the voltage amplifier 40 is configured to receive the reference voltage Vref, and the output end e of the voltage amplifier 40 is connected to the output end of the stored data reading circuit 01. Because the first current mirror 301 amplifies the current Icell output at the first data reading end p of the memory cell into the first mirror current IR 0 through mirroring, and outputs the first mirror current IR 0 to the output end b of the first current mirror 301, and the voltage Vdata at the output end b (that is, at the node D) of the first current mirror 301 is equal to the product of the first mirror current IR 0 and the first resistor 303, when the memory cell stores "1" or "0", a magnitude of the first mirror current IR 0 (where the magnitude of the first mirror current IR 0 may be adjusted by adjusting a length-width ratio of the transistor in the first current mirror 301) and a magnitude of the first resistor 303 may be adjusted to increase the voltage Vdata at the node D, thereby increasing a window when the memory cell stores "1" and "0", that is, increasing a difference between a voltage Vdata1 at the node D when the memory cell stores "1" and a voltage VdataO at the node D when the memory cell stores "0". In this way, even if the window when the memory cell stores "1" and "0" is decreased due to a process deviation, or even if the reference voltage Vref fluctuates, the window when the memory cell stores "1" and "0" has been amplified after the first amplifier 30 is used and can be amplified up to a rail-to-rail (rail-to-rail) level, that is, the voltage Vdata at the node D can reach a maximum power voltage. Therefore, the voltage amplifier 40 can accurately determine the Vdata and reference voltage Vref. In this way, data stored in the memory cell can be distinguished from "0" to "1", ensuring that the memory can correctly read the data.

In some embodiments, as shown in FIG. 4, the stored data reading circuit 01 (or the first amplifier 30) further includes a first switch unit 302. The input end a of the first current mirror 301 is connected to the first data reading end p of the memory cell via the first switch unit 302.

The first switch unit 302 may control the input end a of the first current mirror 301 to be conducted or disconnected from the data reading end p of the memory cell.

For the foregoing reference voltage Vref, in some examples, as shown in FIG. 4, the stored data reading circuit 01 further includes a reference current source Iref; and the second input end d of the voltage amplifier 40 is connected to the reference current source Iref, and the reference voltage Vref is provided for the second input end d of the voltage amplifier 40 by using the reference current source Iref. The other end of the reference current source Iref is grounded. The reference voltage Vref is provided for the second input end d of the voltage amplifier 40 by using the reference current source Iref, so that a magnitude of the reference voltage Vref may be adjusted by adjusting a magnitude of the reference current source Iref.

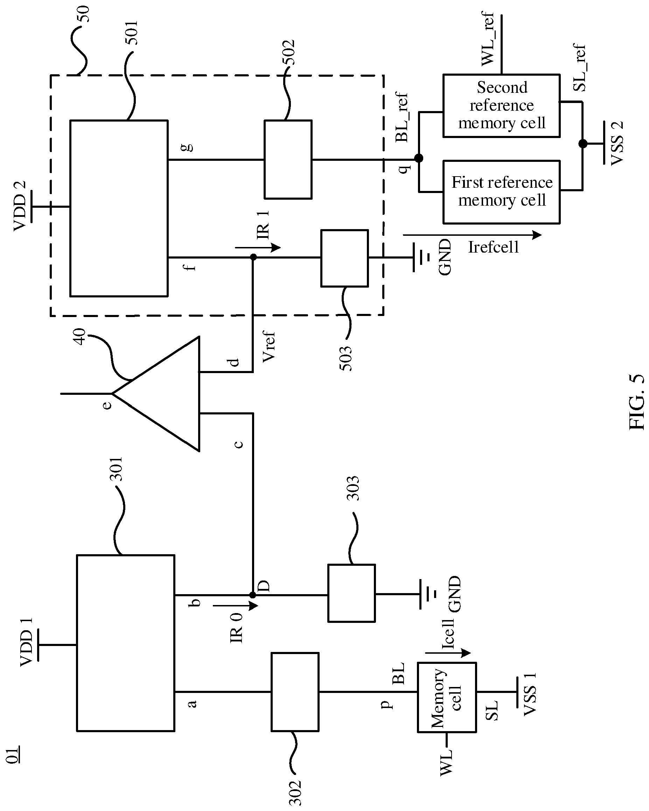

In some other examples, as shown in FIG. 5, the stored data reading circuit 01 further includes a reference current generation circuit 50, and the second input end d of the voltage amplifier 40 is connected to an output end f of the reference current generation circuit 50. The reference current generation circuit 50 includes a second current mirror 501 and a second resistor 503. In this case, the first current mirror 301, the first switch unit 302, the first resistor 303, the second current mirror 501, the second resistor 503, and the like constitute the first amplifier 30. The first amplifier 30 is not shown in FIG. 5.

An input end g of the second current mirror 501 is connected to a second data reading end q of a first reference memory cell and a second reference memory cell that are connected in parallel, and the first reference memory cell and the second reference memory cell are in different storage states. An output end f of the second current mirror 501 is connected to a ground terminal via the second resistor 503, and the output end f of the second current mirror 501 is further connected to the second input end d of the voltage amplifier 40. After the first reference memory cell and the second reference memory cell are enabled by a reference word line WL-ref, the second data reading end q of the first reference memory cell and the second reference memory cell that are connected in parallel outputs a current to the input end g of the second current mirror 501. The second current mirror 501 is configured to: amplify a total current Irefcell output at the second data reading end q into a second mirror current IR 1 through mirroring, and output the second mirror current IR 1 to the output end f of the second current mirror 501. The second current mirror 501 is further connected to a power voltage (for example, a voltage at a second voltage end VDD 2).

The first voltage end VDD 1 and the second voltage end VDD 2 may be the same or may be different.

It may be understood that the second current mirror 501 amplifies the total current Irefcell output at the second data reading end q of the first reference memory cell and the second reference memory cell that are connected in parallel to the second mirror current IR 1 through mirroring. A mirroring amplification multiple is related to a structure of the second current mirror 501. The mirroring amplification multiple of the second current mirror 501, that is, a magnitude of the second mirror current IR 1, may be adjusted by adjusting the structure of the second current mirror 501. Specifically, when the second current mirror 501 includes a transistor, the mirroring amplification multiple of the second current mirror 501, that is, the magnitude of the second mirror current IR 1, may be adjusted by adjusting a width-to-length ratio of the transistor. The output end f of the second current mirror 501 is connected to the second input end d of the voltage amplifier 40, and the output end f of the second current mirror 501 is further connected to the second resistor 503. Therefore, the reference voltage Vref received at the second input end d of the voltage amplifier 40 is equal to a product of the second mirror current IR 1 and the second resistor 503. In view of this, the reference voltage Vref may be adjusted by adjusting the magnitude of the second mirror current IR 1 (where the magnitude of the second mirror current IR 1 may be adjusted by adjusting a length/width ratio of the transistor in the second current mirror 501) and the magnitude of the second resistor 503. Generally, the selected reference voltage Vref is an intermediate value between a Vdata1 when the memory cell stores "1" and a VdataO when the memory cell stores "0".

In addition, the first reference memory cell and the second reference memory cell are in different storage states, which may be that the first reference memory cell stores "1", and the second reference memory cell stores "0"; or may be that the first reference memory cell stores "0", and the second reference memory cell stores "1".

Based on this, the first reference memory cell and the second reference memory cell that are connected in parallel are connected to the reference word line WL-ref, a reference bit line BL-ref, and a reference source line SL-ref. The reference source line SL may be connected to a fourth voltage end VSS 2, or may be grounded. The third voltage end VSS 1 and the fourth voltage end VSS 2 may be the same or may be different.

It should be noted that the first reference memory cell and the second reference memory cell may be reference units that are in a memory cell array of the memory and that are used to perform a read operation and a write operation. For example, when any memory cell in the memory cell array is enabled by the word line and performs a read operation on the memory cell, two memory cells that are in the memory cell array and that do not perform a read operation may be used as the first reference memory cell and the second reference memory cell, and the two memory cells are in different storage states. In this case, the reference word line WL-ref is the word line WL in the memory cell array, the reference bit line BL-ref is a bit line BL in the memory cell array, and the reference source line SL-ref is a source line SL in the memory cell array. Certainly, the first reference memory cell and the second reference memory cell may alternatively be independent of the memory cell array, and may be additionally made separately. In this case, the reference word line WL-ref, the reference bit line BL-ref, and the reference source line SL-ref may alternatively be made separately.

In some embodiments, as shown in FIG. 5, the reference current generation circuit 50 further includes a second switch unit 502, and the input end g of the second current mirror 501 is connected to the second data reading end q via the second switch unit 502.

The second switch unit 502 is configured to control the input end g of the second current mirror 501 to be connected to or disconnected from the second data reading end q.

In this embodiment of this application, the second input end d of the voltage amplifier 40 is connected to the output end f of the reference current generation circuit 50, and the reference current generation circuit 50 provides the reference voltage Vref for the second input end d of the voltage amplifier 40. The reference current generation circuit 50 is connected to the second data reading end q of the first reference memory cell and the second reference memory cell that are connected in parallel, the total current Irefcell output at the second data reading end q of the first reference memory cell and the second reference memory cell is a sum of a current output by the first reference memory cell and a current output by the second reference memory cell, and storage states of the first reference memory cell and the second reference memory cell are opposite. Therefore, it can be ensured that the reference voltage Vref provided at the output end f of the reference current generation circuit 50 is an intermediate value of a voltage when the memory cell stores "1" and a voltage when the memory cell stores "0", which improves the accuracy of the reference voltage Vref, and further ensures that the stored data reading circuit 01 can correctly read the data.

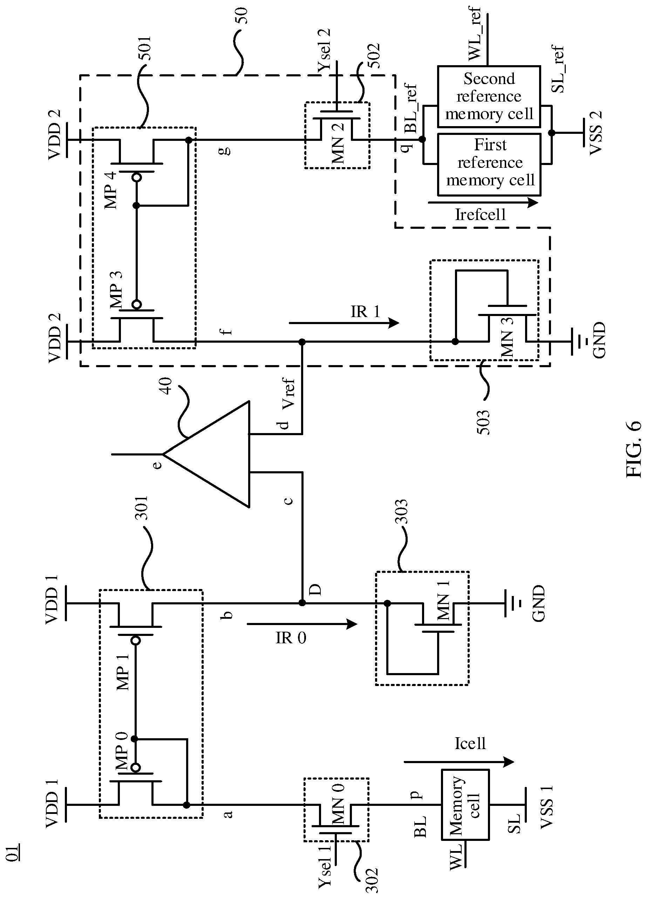

In some embodiments, as shown in FIG. 6, the first current mirror 301 includes a first transistor MP 0 and a second transistor MP 1. A first end of the first transistor MP 0 and a first end of the second transistor MP 1 are both connected to a first voltage end VDD 1, a second end of the first transistor MP 0 is connected to the first data reading end p, and a second end of the second transistor MP 1 is connected to the first resistor 303. A control end of the first transistor MP 0 is connected to a control end of the second transistor MP 1, and the control end of the first transistor MP 0 is connected to the second end of the first transistor MP 0.

It should be noted that a mirroring amplification multiple of the first current mirror 301 may be adjusted by adjusting a width-to-length ratio of the first transistor MP 0 to the second transistor MP 1.

In some embodiments, as shown in FIG. 6, the first switch unit 302 includes a third transistor MN 0. A control end of the third transistor MN 0 is connected to a first control line Ysel 1, a first end is connected to the input end a of the first current mirror 301 (that is, connected to the second end of the first transistor MP 0), and a second end is connected to the first data reading end p of the memory cell.

The first control line Ysel 1 is used to control whether the third transistor MN 0 is conducted.

In some embodiments, the first resistor 303 is a variable resistor (which may also be referred to as a potentiometer). In some other embodiments, as shown in FIG. 6, the first resistor 303 includes a fourth transistor MN 1, a control end of the fourth transistor MN 1 is connected to a first end, a second end of the fourth transistor MN 1 is grounded, and the first end of the fourth transistor MN 1 is connected to the output end b of the first current mirror 301 (that is, connected to the second end of the second transistor MP 1). In this case, a magnitude of the first resistor 303 may be adjusted by adjusting a magnitude (for example, a width-to-length ratio) of the fourth transistor MN 1.

In some embodiments, as shown in FIG. 6, the second current mirror 501 includes a fifth transistor MP 4 and a sixth transistor MP 3. A first end of the fifth transistor MP 4 and a first end of the sixth transistor MP 3 are both connected to a second voltage end VDD 2, a second end of the fifth transistor MP 4 is connected to the second data reading end q, and a second end of the sixth transistor MP 3 is connected to the second input end d of the voltage amplifier 40. A control end of the fifth transistor MP 4 is connected to a control end of the sixth transistor MP 3, and the control end of the fifth transistor MP 4 is connected to the second end of the fifth transistor MP 4.

It should be noted that a mirroring amplification multiple of the second current mirror 501 may be adjusted by adjusting a magnitude (for example, a width-length ratio) of the fifth transistor MP 4 and the sixth transistor MP 3.

In some embodiments, as shown in FIG. 6, the second switch unit 502 includes a seventh transistor MN 2. A control end of the seventh transistor MN 2 is connected to a second control line Ysel 2, a first end is connected to the input end g of the second current mirror 501 (that is, connected to the second end of the fifth transistor MP 4), and a second end is connected to the second data reading end q.

The second control line Ysel 2 is used to control whether the seventh transistor MN 2 is conducted.

In addition, the first control line Ysel 1 and the second control line Ysel 2 may be the same or may be different.

In some embodiments, the second resistor 503 is a variable resistor. In some other embodiments, as shown in FIG. 6, the second resistor 503 includes an eighth transistor MN 3, a control end of the eighth transistor MN 3 is connected to a first end, a second end of the eighth transistor MN 3 is grounded, and the first end of the eighth transistor MN 3 is connected to the second input end d of the voltage amplifier 40 (that is, connected to the second end of the sixth transistor MP 3). In this case, a magnitude of the second resistor 503 may be adjusted by adjusting a magnitude (for example, a width-to-length ratio) of the eighth transistor MN 3.

Based on the foregoing description, it should be noted that the first transistor MP 0, the second transistor MP 1, the third transistor MN 0, the fourth transistor MN 1, the fifth transistor MP 4, the sixth transistor MP 3, the seventh transistor MN 2, and the eighth transistor MN 3 may be P-type transistors, or may be N-type transistors. Types of the first transistor MP 0, the second transistor MP 1, the third transistor MN 0, the fourth transistor MN 1, the fifth transistor MP 4, the sixth transistor MP 3, the seventh transistor MN 2, and the eighth transistor MN 3 may be the same or may not be all the same. In some embodiments, the first transistor MP 0, the second transistor MP 1, the fifth transistor MP 4, and the sixth transistor MP 3 are P-type transistors, and the third transistor MN 0, the fourth transistor MN 1, the seventh transistor MN 2, and the eighth transistor MN 3 are N-type transistors.

Based on the structure of the stored data reading circuit 01 shown in FIG. 5 and FIG. 6 provided in Embodiment 1, an embodiment of this application further provides a control method of a stored data reading circuit, to control the stored data reading circuit 01 provided in Embodiment 1. The control method of the stored data reading circuit includes the following steps.

S10: The first switch unit 302 is in a conduction state, and after the memory cell is enabled by the word line WL, the first data reading end p of the memory cell outputs the current Icell to the input end a of the first current mirror 301, and the first current mirror 301 amplifies the current Icell output at the first data reading end p of the memory cell to the first mirror current IR 0 through mirroring, and outputs the first mirror current IR 0 to the output end b of the first current mirror. The first input end c of the voltage amplifier 40 is connected to the output end b of the first current mirror 301, and the voltage amplifier 40 outputs the signal to the output end of the voltage amplifier 40 according to the voltage Vdata input at the first input end c of the voltage amplifier 40 and the reference voltage Vref received at the second input end d.

It should be noted that, in some embodiments, when the Vdata is greater than the Vref, a high-level voltage is output at the output end e of the voltage amplifier 40, for example, a voltage at the first voltage end VDD 1; or when the Vdata is less than the Vref, a low-level voltage is output at the output end e of the voltage amplifier 40, for example, 0. In a case in which the voltage amplifier 40 includes an inverter, or the voltage amplifier 40 is an amplifier of a special structure (for example, the voltage amplifier 40 is a differential amplifier), in some other embodiments, when the Vdata is greater than the Vref, a low-level voltage is output at the output end e of the voltage amplifier 40, for example, 0; or when the Vdata is less than the Vref, a high-level voltage is output at the output end e of the voltage amplifier 40, for example, a voltage at the first voltage end VDD 1.

### Embodiment 2

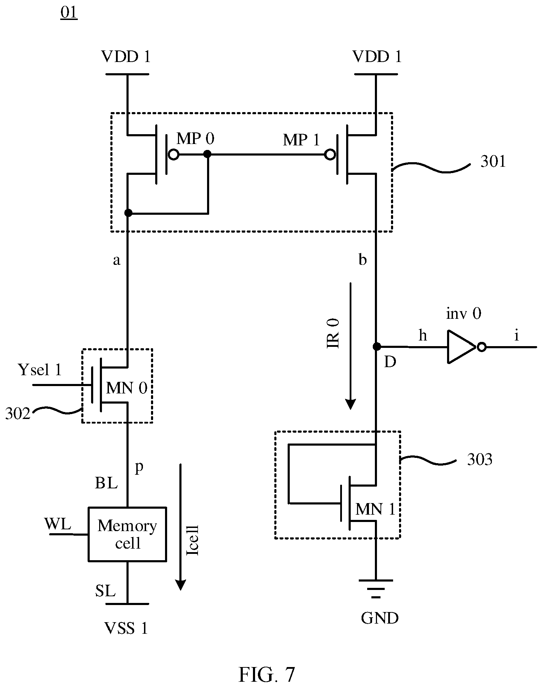

As shown in FIG. 7, the stored data reading circuit 01 includes a first current mirror 301, a first resistor 303, and a first inverter inverter0 (inv 0).

An input end a of the first current mirror 301 is connected to a first data reading end p of a memory cell, an output end b of the first current mirror 301 is connected to a ground terminal via the first resistor 303, and the first current mirror 301 is further connected to a power voltage (for example, a voltage at a first voltage end VDD 1). The memory cell is connected to a word line WL, a bit line BL, and a source line SL. The source line SL may be connected to a third voltage end VSS 1, or may be grounded. After the memory cell is enabled by the word line WL, the first data reading end p of the memory cell outputs a current Icell to the input end a of the first current mirror 301. The first current mirror 301 is configured to: amplify the current Icell output at the first data reading end p of the memory cell to a first mirror current IR 0 through mirroring, and output the first mirror current IR 0 to the output end b of the first current mirror 301.

An input end h of the first inverter inv 0 is connected to the output end b of the first current mirror 301, and an output end i of the first inverter inv 0 is connected to an output end of the stored data reading circuit 01.

It should be understood that, when a voltage Vdata at the output end b (that is, at a node D) of the first current mirror 301 is greater than a threshold voltage of the first inverter inv 0, a low-level voltage is output at the output end i of the first inverter inv 0, for example, 0; or when a voltage Vdata at the output end b of the first current mirror 301 is less than a threshold voltage of the first inverter inv 0, a high-level voltage is output at the output end i of the first inverter inv 0, for example, the voltage at the first voltage end VDD 1.

In this embodiment of this application, because the first current mirror 301 amplifies the current Icell output at the first data reading end p of the memory cell into the first mirror current IR 0 through mirroring, and outputs the first mirror current IR 0 to the output end b of the first current mirror 301, and the voltage Vdata at the output end b (that is, at the node D) of the first current mirror 301 is equal to a product of the first mirror current IR 0 and the first resistor 303, when the memory cell stores "1" or "0", a magnitude of the first mirror current IR 0 (where the magnitude of the first mirror current IR 0 may be adjusted by adjusting a length-width ratio of the transistor in the first current mirror 301) and a magnitude of the first resistor 303 may be adjusted to increase the voltage Vdata at the node D, thereby increasing a window when the memory cell stores "1" and "0", that is, increasing a difference between a voltage Vdata 1 at the node D when the memory cell stores "1" and a voltage VdataO at the node D when the memory cell stores "0". In this way, even if the window when the memory cell stores "1" and "0" is decreased due to a process deviation, or even if the reference voltage Vref fluctuates, the window when the memory cell stores "1" or "0" has been amplified. For the first inverter inv 0, when the voltage Vdata at the output end b of the first current mirror 301 is greater than a threshold voltage of the first inverter inv 0, the low-level voltage is output at the output end i of the first inverter inv 0; or when the voltage Vdata at the output end b of the first current mirror 301 is less than a threshold voltage of the first inverter inv 0, the high-level voltage is output at the output end i of the first inverter inv 0. Therefore, the first inverter inv 0 can accurately determine the Vdata. In this way, data stored in the memory cell can be distinguished from "0" to "1", ensuring that the memory can correctly read the data.

In some embodiments, as shown in FIG. 7, the stored data reading circuit 01 further includes a first switch unit 302. The input end a of the first current mirror 301 is connected to the data reading end p of the memory cell via the first switch unit 302.

The first switch unit 302 may control the input end a of the first current mirror 301 to be conducted or disconnected from the data reading end p of the memory cell.

It should be noted that, for the first current mirror 301, the first switch unit 302, and the first resistor 303, refer to the description of the foregoing embodiment. Details are not described herein again.

Based on the structure of the stored data reading circuit 01 shown in FIG. 7 provided in Embodiment 2, an embodiment of this application further provides a control method of a stored data reading circuit, to control the stored data reading circuit 01 provided in Embodiment 2. The control method of the stored data reading circuit includes the following steps.

S20: The first switch unit 302 is in a conduction state, and after the memory cell is enabled by the word line WL, the first data reading end p of the memory cell outputs the current Icell to the input end a of the first current mirror 301, and the first current mirror 301 amplifies the current Icell output by the memory cell to the first mirror current IR 0, and outputs the first mirror current IR 0 to the output end b of the first current mirror. The input end h of the first inverter inv 0 is connected to the output end b of the first current mirror 301. The first inverter inv 0 outputs a signal to the output end i of the first inverter inv 0 according to the voltage input at the input end h of the first inverter inv 0.

The first inverter inv 0 outputs the signal to the output end i of the first inverter inv 0 according to the voltage input at the input end h of the first inverter inv 0. For details, refer to the foregoing descriptions. Details are not described herein again.

### Embodiment 3

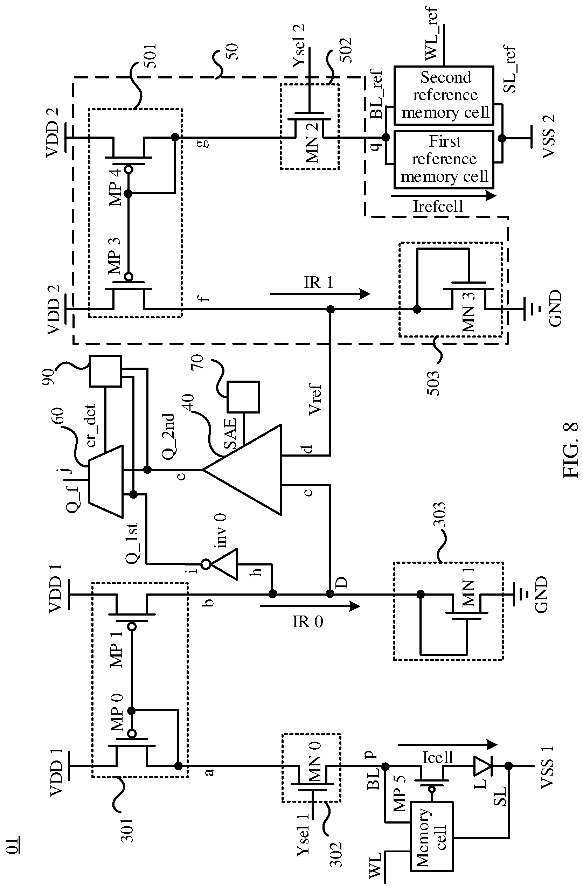

As shown in FIG. 8, the stored data reading circuit 01 includes a first current mirror 301, a first resistor 303, a voltage amplifier 40, a first inverter inv 0, and a first multiplexer (multiplexer, MUX) 60.

An input end a of the first current mirror 301 is connected to a first data reading end p of a memory cell, an output end b of the first current mirror 301 is connected to a ground terminal via the first resistor 303, and the first current mirror 301 is further connected to a power voltage (for example, a voltage at a first voltage end VDD 1). The memory cell is connected to a word line WL, a bit line BL, and a source line SL. The source line SL may be connected to a third voltage end VSS 1, or may be grounded. After the memory cell is enabled by the word line WL, the first data reading end p of the memory cell outputs a current Icell to the input end a of the first current mirror 301. The first current mirror 301 is configured to: amplify the current Icell output at the first data reading end p of the memory cell to a first mirror current IR 0 through mirroring, and output the first mirror current IR 0 to the output end b of the first current mirror 301.

A first input end c of the voltage amplifier 40 is connected to an output end b of the first current mirror 301, and a second input end d of the voltage amplifier 40 is configured to receive a reference voltage Vref. The voltage amplifier 40 is configured to perform inverting output on a difference between a voltage Vdata input at the first input end c of the voltage amplifier 40 and a voltage Vref input at the second input end d. In other words, the voltage amplifier 40 is configured to perform inverting output on a difference between a voltage Vdata output at the output end b of the first current mirror 301 and a reference voltage Vref received at the second input end d of the voltage amplifier 40.

An input end h of the first inverter inv 0 is connected to the output end b of the first current mirror 301, an output end i of the first inverter inv 0 is connected to a first input end of the first multiplexer 60, an output end e of the voltage amplifier 40 is connected to a second input end of the first multiplexer 60, and an output end j of the first multiplexer 60 is connected to an output end of the stored data reading circuit 01.

In some embodiments, as shown in FIG. 8, the stored data reading circuit 01 further includes a first switch unit 302. The input end a of the first current mirror 301 is connected to the data reading end p of the memory cell via the first switch unit 302.

The first switch unit 302 may control the input end a of the first current mirror 301 to be conducted or disconnected from the data reading end p of the memory cell. It should be noted that, for the first current mirror 301, the first switch unit 302, the first resistor 303, and the first inverter inv 0, refer to the description of the foregoing embodiment. Details are not described herein again.

In addition, the second input end d of the voltage amplifier 40 may be connected to a reference current source Iref, and the reference current source Iref provides the reference voltage Vref for the second input end d of the voltage amplifier 40; or may be connected to an output end f of the reference current generation circuit 50, and the reference current generation circuit 50 provides the reference voltage Vref for the second input end d of the voltage amplifier 40. For details about the reference current source Iref and the reference current generation circuit 50, reference may be made to Embodiment 1. Details are not described herein again.

Based on this, the voltage amplifier 40 is configured to perform inverting output on the difference between the voltage Vdata input at the first input end c of the voltage amplifier 40 and the voltage Vref input at the second input end d. Therefore, when the Vdata is greater than the Vref, a low-level voltage is output at the output end e of the voltage amplifier 40, for example, 0; or when the Vdata is less than the Vref, a high-level voltage is output at the output end e of the voltage amplifier 40, for example, a voltage at the first voltage end VDD 1. In view this, in some embodiments, the voltage amplifier 40 provided in this embodiment includes an inverter. In some other embodiments, the voltage amplifier 40 is an amplifier of a special structure. For example, the voltage amplifier 40 is a differential amplifier.

The output end j of the first multiplexer 60 selects one of the first input end and the second input end of the first multiplexer 60 for output. In some embodiments, as shown in FIG. 8, the stored data reading circuit 01 further includes an error detection circuit 90. A control end of the first multiplexer 60 is electrically connected to the error detection circuit 90. The error detection circuit 90 is connected to the output end i of the first inverter inv 0 and the output end e of the voltage amplifier 40. The error detection circuit 90 is configured to output an error detection (er-det) signal according to a signal Q-first (Q-1st) output at the output end i of the first inverter inv 0 and a signal Q-second (Q-2nd) output at the output end e of the voltage amplifier 40. The first multiplexer 60 determines, according to the error detection er-det signal, that a signal Q-final (Q-f) output at the output end j of the first multiplexer 60 is the signal Q-1st output at the output end i of the first inverter inv 0 or the signal Q-2nd output at the output end e of the voltage amplifier 40. For example, if the Q-1st and the Q-2nd are the same, the first multiplexer 60 selects to output the Q-1st or the Q-2nd; or if the Q-1st and the Q-2nd are different, the first multiplexer 60 selects to output the Q-1st.

It should be noted that the error detection circuit 90 may be implemented by using a logical operation gate. For example, the error detection circuit 90 includes an XOR gate, where one input end of the XOR gate is connected to the output end i of the first inverter inv 0, the other input end is connected to the output end e of the voltage amplifier 40, and an output end of the XOR gate is connected to the control end of the first multiplexer 60.

In some embodiments, as shown in FIG. 8, an enable signal end (sense amplifier enable) of the voltage amplifier 40 is connected to an enable signal control circuit 70. The enable signal control circuit 70 provides an enable signal for the enable signal end SAE of the voltage amplifier 40, to enable the voltage amplifier 40.

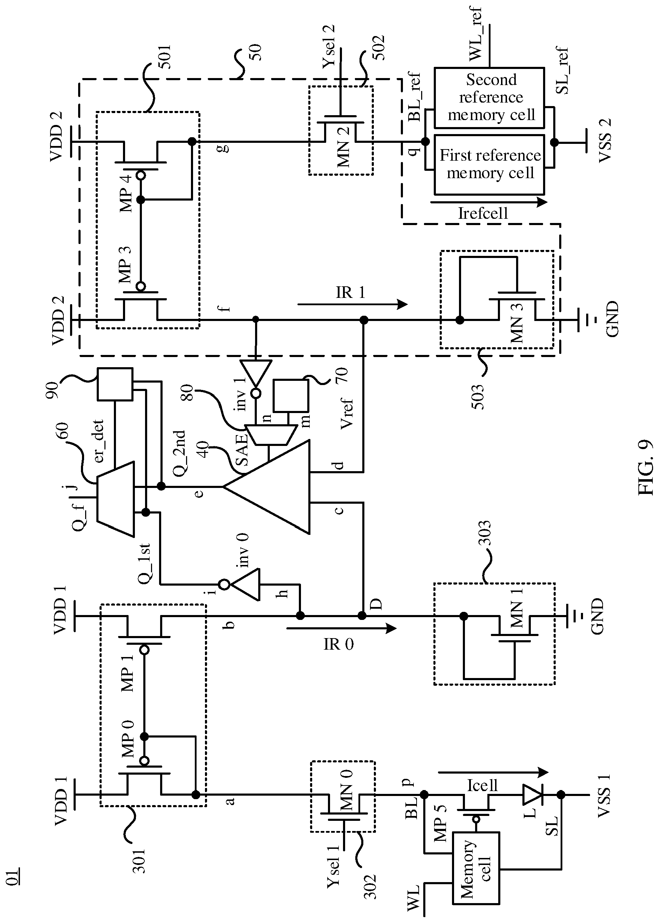

In some other embodiments, when the second input end d of the voltage amplifier 40 is connected to the output end of the reference current generation circuit 50, as shown in FIG. 9, the stored data reading circuit 01 further includes a second multiplexer 80. The enable signal end SAE of the voltage amplifier 40 is connected to an output end of the second multiplexer 80, the enable signal control circuit 70 is connected to a first input end m of the second multiplexer 80, and the output end of the reference current generation circuit 50 is connected to a second input end n of the second multiplexer 80.

In some examples, when the enable signal end SAE of the voltage amplifier 40 provides a high-level signal, the voltage amplifier 40 compares a voltage input at the first input end c of the voltage amplifier 40 with a voltage input at the second input end d of the voltage amplifier 40, and outputs a signal at the output end e of the voltage amplifier 40. In this case, the voltage amplifier 40 with the high-level signal works. In some other examples, when the enable signal end SAE provides a low-level signal, the voltage amplifier 40 compares a voltage input at the first input end c of the voltage amplifier 40 with a voltage input at the second input end d of the voltage amplifier 40, and outputs a signal at the output end e of the voltage amplifier 40. In this case, the voltage amplifier 40 with the low-level signal works. In this case, the output end of the reference current generation circuit 50 is connected to the second input end n of the second multiplexer 80 via a second inverter inverter 1 (inv 1). Specifically, an input end of the second inverter inv 1 is connected to the output end of the reference current generation circuit 50, and an output end of the second inverter inv 1 is connected to the second input end n of the second multiplexer 80.

It should be noted that, when the enable signal end SAE of the voltage amplifier 40 is connected to the output end of the second multiplexer 80, the second multiplexer 80 may choose the enable signal control circuit 70 to provide the enable signal for the enable signal end SAE of the voltage amplifier 40, or may choose a signal output by the second inverter inv 1 to provide the enable signal for the enable signal end SAE of the voltage amplifier 40.

Because the voltage at the node D gradually increases, if the first input end c of the voltage amplifier 40 obtains the voltage Vdata at the node D excessively early, the voltage Vdata received at the first input end c of the voltage amplifier 40 may be inaccurate, causing an incorrect value output by the voltage amplifier 40. In this embodiment of this application, the enable signal end SAE of the voltage amplifier 40 is connected to the output end of the second multiplexer 80, and the second input end n of the second multiplexer 80 is connected to the output end of the reference current generation circuit 50. Because the input end g of the second current mirror 501 in the reference current generation circuit 50 is connected to the second data reading end a of the first reference memory cell and the second reference memory cell that are connected in parallel, and the first reference memory cell and the second reference memory cell are known reference units, it may be determined whether the second output end d of the voltage amplifier 40 receives the correct reference voltage Vref within a predetermined time period. In this way, when the reference current generation circuit 50 provides the correct reference voltage Vref, a signal may be provided for the second input end n of the second multiplexer 80, and the signal may be provided for the enable signal end SAE of the voltage amplifier 40. In this case, the enable signal end SAE of the voltage amplifier 40 provides the enable signal for the voltage amplifier 40 to enable the voltage amplifier 40, and the voltage amplifier 40 outputs the signal from the output end e of the voltage amplifier 40 based on the difference between the reference voltage Vref input at the first input end c and the voltage Vdata input at the second input end d. In this case, the voltage Vdata received at the first input end c of the voltage amplifier 40 is stable, which improves the stability of the signal output at the output end of the voltage amplifier 40.

Based on the foregoing description, in some embodiments, as shown in FIG. 8 and FIG. 9, the memory cell is further connected to a control end of a ninth transistor MP 5, a first end of the ninth transistor MP 5 is connected to a bit line BL, and a second end is connected through a diode L and a source line SL. In addition, the ninth transistor MP 5 may be a P-type transistor, or may be an N-type transistor.

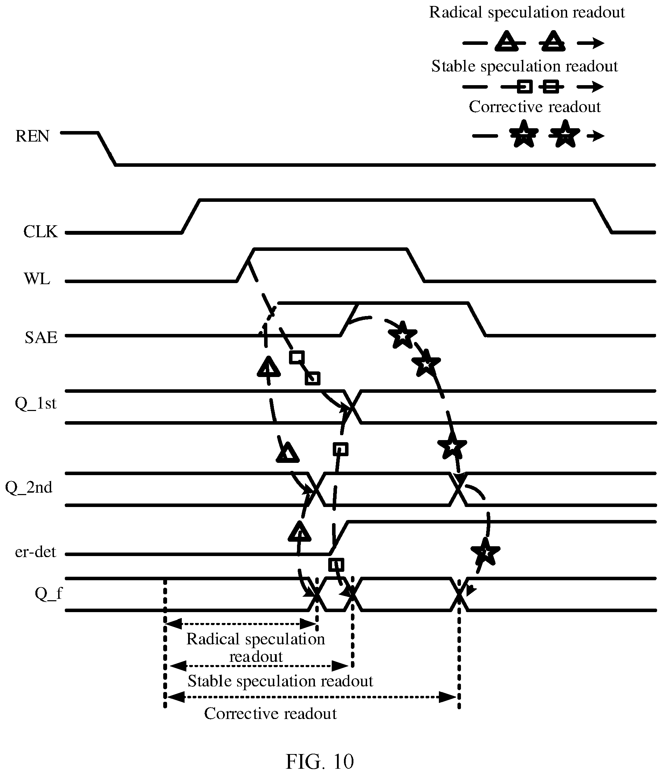

Based on the structure of the stored data reading circuit 01 shown in FIG. 8 and FIG. 9 provided in Embodiment 3, an embodiment of this application further provides a control method of a stored data reading circuit 01, to control the stored data reading circuit 01 provided in Embodiment 3. Referring to a time sequence diagram shown in FIG. 10, the time sequence diagram separately provides a time sequence curve of a read enable signal REN, a time sequence curve of a read clock signal CLK, a time sequence curve of a signal output by using a word line WL, a time sequence curve of the enable signal output by the enable signal end SAE of the voltage amplifier 40, a time sequence curve of the signal Q-1st output at the output end i of the first inverter inv 0, and a time sequence curve of the signal Q-2nd output at the output end e of the voltage amplifier 40, a time sequence curve of the signal Q-f output at the output end j of the first multiplexer 60; and a time sequence curve of the error detection er-det signal.

With reference to the sequence diagram shown in FIG. 10, the control method of the stored data reading circuit 01 includes the following steps.

S30: In a first phase, the first switch unit 302 is in a conduction state, and after the memory cell is enabled by the word line WL, the first data reading end p of the memory cell outputs the current Icell to the input end a of the first current mirror 301, and the first current mirror 301 amplifies the current Icell output at the first data reading end p of the memory cell to the first mirror current IR 0 through mirroring, and outputs the first mirror current IR 0 to the output end b of the first current mirror 301. The first input end c of the voltage amplifier 40 is connected to the output end b of the first current mirror 301; the enable signal end SAE of the voltage amplifier 40 provides the enable signal for the voltage amplifier 40 to enable the voltage amplifier 40; the voltage amplifier 40 outputs a signal to the output end e of the voltage amplifier 40 according to the voltage Vdata input at the first input end c of the voltage amplifier 40 and the reference voltage Vref input at the second input end d, and the output end j of the first multiplexer 60 selects to output the signal Q-2nd output at the output end e of the voltage amplifier 40.

Referring to FIG. 10, when the read enabling signal REN is provided, the stored data reading circuit 01 starts a read operation. The signal provided by using the word line WL selects the to-be-read memory cell. Within a short period of a fixed delay after a rise edge of the read clock signal CLK arrives, the enable signal end SAE of the voltage amplifier 40 provides the enable signal, and the voltage amplifier 40 outputs the signal Q-2nd to the output end e of the voltage amplifier 40 according to the voltage Vdata input at the first input end c of the voltage amplifier 40 and the reference voltage Vref input at the second input end d. In this phase, the output end j of the first multiplexer 60 selects to output the signal Q-2nd output at the output end e of the voltage amplifier 40.

In addition, in the first phase, the enable signal may be provided for the enable signal end SAE of the voltage amplifier 40 via the enable signal control circuit 70.

It should be noted that, because the fixed delay is generally set to be excessively small, in the first phase, the output end j of the first multiplexer 60 may quickly output the signal Q-f, and in this case, the Q-f is the Q-2nd. Because this mode is relatively radical, an operation in this phase may also be referred to as a radical speculation readout operation.

S31: In a second phase, the voltage amplifier 40 is not enabled by the enable signal end SAE of the voltage amplifier 40 (that is, the voltage amplifier 40 does not output a signal); if the signal Q-1st output by the first inverter inv 0 is the same as the signal Q-2nd output by the first multiplexer 60 in the first phase (the signal output by the first multiplexer 60 in the first phase is the signal Q-2nd output by the voltage amplifier 40), the first multiplexer 60 keeps outputting the signal Q-2nd output by the voltage amplifier 40 in the first phase. If the signal Q-1st output by the first inverter inv 0 is different from the signal Q-2nd output by the first multiplexer 60 in the first phase, the first multiplexer 60 is controlled to choose to output the signal Q-1st output by the first inverter inv 0.

In the second phase, the error detection er-det signal output by the error detection circuit 90 may be used to control the first multiplexer 60 to select to output the signal Q-1st output by the first inverter inv 0. For details about the error detection circuit 90, reference may be made to the foregoing embodiments. Details are not described herein again.

It should be noted that, in the first phase, the output end j of the first multiplexer 60 quickly outputs the signal Q-f in a short time. In this case, the difference between the voltage Vdata input at the first input end c of the voltage amplifier 40 and the reference voltage Vref input at the second input end d may not reach a particularly ideal range. For example, the difference between the voltage Vdata input at the first input end c of the voltage amplifier 40 and the reference voltage Vref input at the second input end d may be less than sensitivity of the voltage amplifier 40, and under the influence of factors such as a process deviation, the difference between the Vdata and the Vref may not be enough to enable the voltage amplifier 40 to work correctly, and there is a probability of misreading. On one hand, a threshold voltage of the first inverter inv 0 is generally large, and on the other hand, a reading time in the second phase is later than a reading time in the first phase. Therefore, there is a high probability that the signal Q-1st output by the first inverter inv 0 is accurate. In this way, in the second phase, when the signal Q-1st output by the first inverter inv 0 is different from the signal Q-2nd output by the voltage amplifier 40 in the first phase, the signal Q-f output at the output end j of the first multiplexer 60 is the signal Q-1st output by the first inverter inv 0.

When the voltage Vdata received at the input end h of the first inverter inv 0 is greater than the threshold voltage of the first inverter inv 0, the low-level voltage is output at the output end i of the first inverter inv 0; or when the voltage Vdata received at the input h of the first inverter inv 0 is less than the threshold voltage of the first inverter inv 0, the high-level voltage is output at the output end i of the first inverter inv 0. Because the voltage Vdata received at the input end h of the first inverter inv 0 has been amplified when the memory cell stores "1" and "0", the voltage Vdata can be amplified up to a rail-to-rail level, that is, the voltage Vdata at the node D can reach a maximum power voltage. In this way, the accuracy of the signal Q-1st output at the output end i of the first inverter inv 0 can be ensured. In addition, an operation in this phase may also be referred to as a stable speculation readout operation.

S32: In a third phase, the enable signal end SAE of the voltage amplifier 40 provides the enable signal for the voltage amplifier 40 to enable the voltage amplifier 40, and the output end e of the voltage amplifier 40 outputs the signal Q-2nd. If the signal Q-2nd output by the voltage amplifier 40 is the same as the signal Q-1st output by the first multiplexer 60 in the second phase (the signal output by the first multiplexer 60 in the second phase is the signal Q-1st output by the first inverter inv 0), in this case, the first multiplexer 60 keeps outputting the signal Q-1st output by the first multiplexer 60 in the second phase; and if the signal Q-2nd output by the voltage amplifier 40 is different from the signal Q-1st output by the first multiplexer 60 in the second phase, the first multiplexer 60 is controlled to select to output the signal Q-2nd output by the voltage amplifier 40.

It should be understood that, in the second phase and the third phase, the first switch unit 302 is still in the conduction state, and the memory cell is enabled by the word line WL.

After the first phase and the second phase, the voltage Vdata input at the first input end c of the voltage amplifier 40 has enough time to be amplified, and a voltage difference has been formed between the voltage Vdata input at the first input end c and the reference voltage Vref. Therefore, complete amplification on the window has been performed in the third phase.

In addition, in the third phase, the enable signal provided by the enable signal end SAE of the voltage amplifier 40 may be provided by the enable signal control circuit 70, or may be provided by the reference current generation circuit 50. When the enable signal provided by the enable signal end SAE is provided by the reference current generation circuit 50, it can be further ensured that the window is completely amplified. For a specific reason, refer to the foregoing embodiment. Details are not described herein again.

In a relatively poor process deviation or in an extreme case, the signal Q-1st output at the output end j of the first multiplexer 60 in the second phase may also be incorrect. Because the window has been completely amplified in the third phase, the voltage amplifier 40 can perform correct amplification even in a relatively poor process deviation or in an extreme case, thereby ensuring correctness of the signal output at the output end e of the voltage amplifier 40. In view of this, an operation in this phase may also be referred to as a corrective read operation.

It should be noted that step S32 is an optional step, for example, may be omitted in some embodiments.

The following provides a specific embodiment to analyze an effect achieved by the foregoing stored data reading circuit.

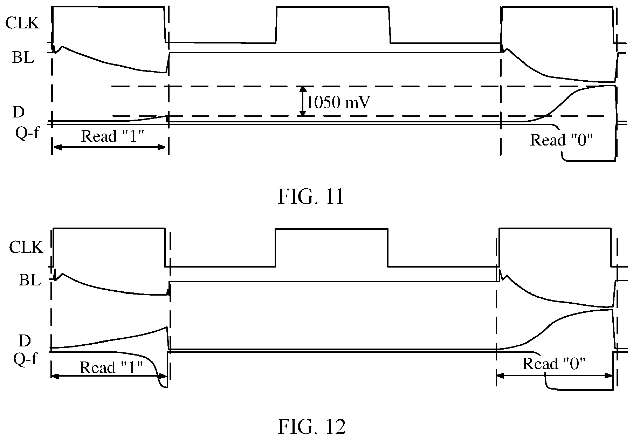

In an ideal condition with a typical process corner (typical corner), a temperature of 25 °C, and a power voltage of 1.2 V, if the signal Q-f output by the first multiplexer 60 is used as the signal Q-1st output by the first inverter inv 0 to perform operations of reading "0" and "1", as shown in FIG. 11, it can be learned that "1" and "0" can be correctly read based on the signal Q-f output at the output end j of the first multiplexer 60. After the voltage at D is amplified, the window of the memory cell becomes 1050 mV, which is almost at a logical high level. Therefore, Q can be correctly identified.

However, in a high temperature and high leakage current condition with a fast process corner (fast corner), a temperature of 125 °C, and a power voltage of 1.32 V, if the signal Q-1st output by the first inverter inv 0 is only used as the signal Q-f output by the first multiplexer 60, in the high temperature and high leakage current condition, when a clock periodicity becomes longer, an error occurs in reading "1". Referring to FIG. 12, it can be learned that, in a high temperature and high leakage condition, when "1" is read, a voltage at D increases. In this way, the signal Q-1st output by the first inverter inv 0 is a low-level signal, and therefore is read as "0" by mistakes. Therefore, in an extreme case, the signal Q-1st output by the first inverter inv 0 is used as the signal Q-f output by the first multiplexer 60, causing misreading. In other words, the stable read operation is incorrect.

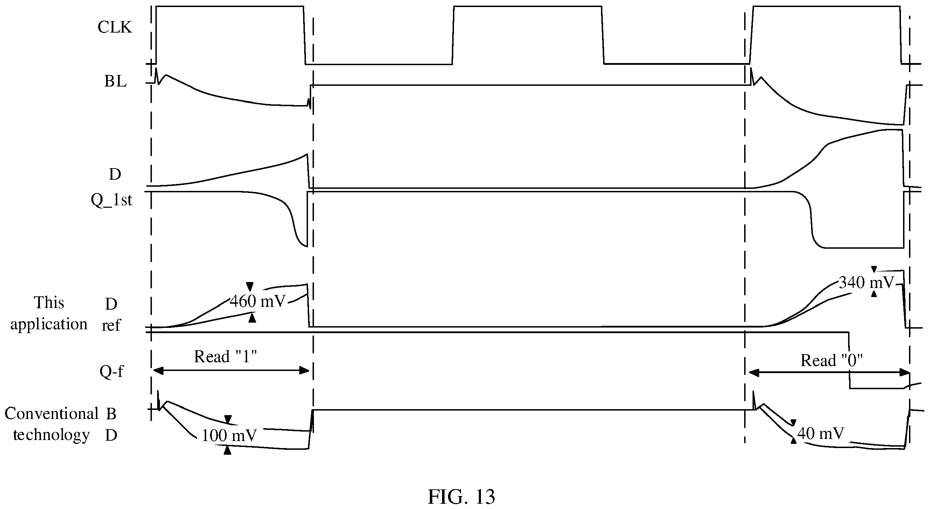

After an error occurs in the stable read operation, the data read by using the corrective read operation may be used to update the data read by using the stable read operation. A specific process is as follows: The enable signal end SAE of the voltage amplifier 40 provides the enable signal for the voltage amplifier 40 to enable the voltage amplifier 40, and the voltage amplifier 40 compares the voltage Vdata at D with the reference voltage Vref, to output the signal Q-2nd at the output end e of the voltage amplifier 40. Under the foregoing high temperature and high leakage current condition, the signal Q-f finally output by the first multiplexer 60 is the output signal Q-2nd output at the output end e of the voltage amplifier 40. Referring to FIG. 13, although the signal Q-1st output by the first inverter inv 0 is directly read incorrectly, after the voltage amplifier 40 performs correction, the signal Q-f output by the first multiplexer 60 is finally the Q-2nd, so that "1" and "0" can be correctly read.

Based on this, referring to FIG. 13, in the conventional technology, a total window processed by the second-stage amplifier 20 in FIG. 13 is about 140 mV (100 mV + 40 mV), and a minimum window is 40 mV However, in this embodiment of this application, a total window processed by the voltage amplifier 40 is 800 mV (460 mV + 340 mV), and a minimum window is 340 mV Compared with that in the conventional technology, in this embodiment of this application, the total window is increased by 471% ((800 - 140)/140 = 471%), and the minimum window is increased by 750% ((340 - 40)/40 = 750%). It can be learned from the test result that, in a process deviation condition, this embodiment of this application effectively improves the accuracy of reading data by the stored data reading circuit 01.

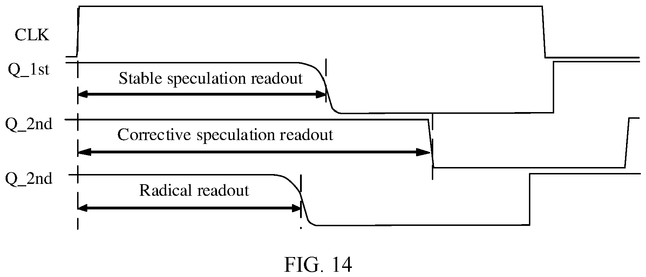

As shown in FIG. 14, an example in which the stored data reading circuit reads "0" is used to provide waveform diagrams of radical speculation readout, stable speculation readout, and corrective readout. In this embodiment of this application, performance of the stored data reading circuit 01 is evaluated by using a read speed of the stored data reading circuit 01. To ensure correctness of the data read by the stored data reading circuit 01, the data stored in the memory cell is read by using the corrective readout. However, it can be learned from FIG. 14 that the corrective readout has no advantage in performance. In this embodiment of this application, the performance may be improved by using the radical readout and the stable readout. The time required for the radical speculation readout, the stable speculation readout, and the corrective readout is detected, as shown in Table 1.

**Table 1**

| | Radical speculation readout | Stable speculation readout | Corrective readout | Optimization ratio |
|---|---|---|---|---|
| Time (ns) | 36 | 42 | 62 | 32.25%-41.9% |

Referring to Table 1, the time required for radical speculation readout is 36 ns, the time required for stable speculation readout is 42 ns, and the time required for corrective readout is 62 ns. Compared with the corrective readout, the radical speculation readout improves the performance by 41.9% ((62 - 36)/62 = 41.9%), and the stable speculation readout improves the performance by 32.25% ((62 - 42)/62 = 32.25%).

Based on the foregoing description, in this embodiment of this application, the window can be effectively amplified, thereby avoiding misreading caused by a process deviation and a feature of a new memory cell. In addition, by using the corrective readout, it can be ensured that the stored data reading circuit 01 can correctly read the data in a process deviation case. Based on this, performance of the stored data reading circuit 01 may further be improved by using the radical speculation readout and the stable speculation readout.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A stored data reading circuit, comprising a first current mirror, a first resistor, and a voltage amplifier, wherein
an input end of the first current mirror is connected to a first data reading end of a memory cell, an output end of the first current mirror is connected to a ground terminal via the first resistor, and the first current mirror is configured to: amplify a current output at the first data reading end of the memory cell to a first mirror current through mirroring, and output the first mirror current to the output end of the first current mirror; and
a first input end of the voltage amplifier is connected to the output end of the first current mirror, a second input end of the voltage amplifier is configured to receive a reference voltage, and an output end of the voltage amplifier is connected to an output end of the stored data reading circuit.

2. The stored data reading circuit according to claim 1, wherein the stored data reading circuit further comprises a first inverter and a first multiplexer; and the output end of the voltage amplifier is connected to the output end of the stored data reading circuit via the first multiplexer;
an input end of the first inverter is connected to the output end of the first current mirror, an output end of the first inverter is connected to a first input end of the first multiplexer, and the output end of the voltage amplifier is connected to a second input end of the first multiplexer;
an output end of the first multiplexer is connected to the output end of the stored data reading circuit; and
the voltage amplifier is configured to perform inverting output on a difference between a voltage input at the first input end of the voltage amplifier and a voltage input at the second input end of the voltage amplifier.

3. The stored data reading circuit according to claim 1 or 2, wherein the stored data reading circuit further comprises a reference current source, the second input end of the voltage amplifier is connected to the reference current source, and the reference voltage is provided for the second input end of the voltage amplifier by using the reference current source.

4. The stored data reading circuit according to claim 1 or 2, wherein the stored data reading circuit further comprises a reference current generation circuit, and the second input end of the voltage amplifier is connected to an output end of the reference current generation circuit;
the reference current generation circuit comprises a second current mirror and a second resistor; and
an input end of the second current mirror is connected to a second data reading end of a first reference memory cell and a second reference memory cell that are connected in parallel, an output end of the second current mirror is connected to a ground terminal via the second resistor, the output end of the second current mirror is further connected to the second input end of the voltage amplifier, and the second current mirror is configured to: amplify a total current output at the second data reading end to a second mirror current through mirroring, and output the second mirror current to the output end of the second current mirror, wherein
the first reference memory cell and the second reference memory cell are in different storage states.

5. The stored data reading circuit according to any one of claims 1 to 4, wherein an enable signal end of the voltage amplifier is connected to an enable signal control circuit.

6. The stored data reading circuit according to claim 4, wherein the stored data reading circuit further comprises a second multiplexer, an enable signal end of the voltage amplifier is connected to an output end of the second multiplexer, an enable signal control circuit is connected to a first input end of the second multiplexer, and the output end of the reference current generation circuit is connected to a second input end of the second multiplexer.

7. The stored data reading circuit according to claim 2, wherein the stored data reading circuit further comprises an error detection circuit, and a control end of the first multiplexer is electrically connected to the error detection circuit, wherein
the error detection circuit is connected to the output end of the first inverter and the output end of the voltage amplifier, and the error detection circuit is configured to output an error detection signal based on a signal output at the output end of the first inverter and a signal output at the output end of the voltage amplifier; and
the first multiplexer determines, based on the error detection signal, that the output end of the first multiplexer outputs the signal output at the output end of the first inverter or the signal output at the output end of the voltage amplifier.

8. The stored data reading circuit according to claim 1, wherein the stored data reading circuit further comprises a first switch unit; and
the input end of the first current mirror is connected to the first data reading end of the memory cell via the first switch unit.

9. The stored data reading circuit according to claim 4, wherein the reference current generation circuit further comprises a second switch unit; and
the input end of the second current mirror is connected to the second data reading end via the second switch unit.

10. The stored data reading circuit according to any one of claims 1 to 9, wherein the first current mirror comprises a first transistor and a second transistor; and
a first end of the first transistor and a first end of the second transistor are both connected to a first voltage end, a second end of the first transistor is connected to the first data reading end, a second end of the second transistor is connected to the first resistor, a control end of the first transistor is connected to a control end of the second transistor, and the control end of the first transistor is connected to the second end of the first transistor.

11. The stored data reading circuit according to any one of claims 1 to 10, wherein the first resistor comprises a fourth transistor, a control end of the fourth transistor is connected to a first end, a second end of the fourth transistor is grounded, and the first end of the fourth transistor is connected to the output end of the first current mirror.

12. The stored data reading circuit according to claim 4, wherein the second current mirror comprises a fifth transistor and a sixth transistor; and
a first end of the fifth transistor and a first end of the sixth transistor are both connected to a second voltage end, a second end of the fifth transistor is connected to the second data reading end, a second end of the sixth transistor is connected to the second input end of the voltage amplifier, a control end of the fifth transistor is connected to a control end of the sixth transistor, and the control end of the fifth transistor is connected to the second end of the fifth transistor.

13. The stored data reading circuit according to claim 4 or 12, wherein the second resistor comprises an eighth transistor, a control end of the eighth transistor is connected to a first end, a second end of the eighth transistor is grounded, and the first end of the eighth transistor is connected to the second input end of the voltage amplifier.

14. The stored data reading circuit according to claim 8, wherein the first switch unit comprises a third transistor; a control end of the third transistor is connected to a first control line, a first end is connected to the input end of the first current mirror, and a second end is connected to the first data reading end.

15. The stored data reading circuit according to claim 9, wherein the second switch unit comprises a seventh transistor; a control end of the seventh transistor is connected to a second control line, a first end is connected to the input end of the second current mirror, and a second end is connected to the second data reading end.

16. A stored data reading circuit, comprising a first current mirror, a first resistor, and a first inverter, wherein
an input end of the first current mirror is connected to a first data reading end of a memory cell, an output end of the first current mirror is connected to a ground terminal via the first resistor, and the first current mirror is configured to: amplify a current output at the first data reading end of the memory cell to a first mirror current through mirroring, and output the first mirror current to the output end of the first current mirror; and
an input end of the first inverter is connected to the output end of the first current mirror, and an output end of the first inverter is connected to an output end of the stored data reading circuit.

17. The stored data reading circuit according to claim 16, wherein the stored data reading circuit further comprises a first switch unit; and
the input end of the first current mirror is connected to the data reading end of the memory cell via the first switch unit.

18. The stored data reading circuit according to claim 16, wherein the first current mirror comprises a first transistor and a second transistor; and
a first end of the first transistor and a first end of the second transistor are both connected to a first voltage end, a second end of the first transistor is connected to the first data reading end, a second end of the second transistor is connected to the first resistor, a control end of the first transistor is connected to a control end of the second transistor, and the control end of the first transistor is connected to the second end of the first transistor.

19. The stored data reading circuit according to claim 16, wherein the first resistor comprises a fourth transistor, a control end of the fourth transistor is connected to a first end, a second end of the fourth transistor is grounded, and the first end of the fourth transistor is connected to the output end of the first current mirror.

20. The stored data reading circuit according to claim 17, wherein the first switch unit comprises a third transistor; a control end of the third transistor is connected to a first control line, a first end is connected to the input end of the first current mirror, and a second end is connected to the first data reading end.

21. A memory, comprising a plurality of memory cells distributed in an array and at least one stored data reading circuit according to any one of claims 1 to 20.
